# EUROPEAN PATENT APPLICATION

(11) **EP 4 704 333 A1**
(43) Date of publication of application: **04.03.2026**
(21) Application number: 25197925.8
(22) Date of filing: 25.08.2025
(51) Int. Cl.: H02S 40/20, H02S 40/42, H04B 10/80, H10F 77/124, H10F 77/50, H10F 77/63

(54) **OPTICAL POWER CONVERTERS AND GALVANICALLY ISOLATED POWER SUPPLIES**

(30) Priority: 27.08.2024 US 202418817080
(71) Applicant: Avago Technologies International Sales Pte. Limited, Singapore 768923 (SG)
(72) Inventor: Fafard, Simon, Orleans K1W 1G3 (CA); Masson, Denis, Ottawa K1J 8J5 (CA)
(74) Representative: Dilg, Haeusler, Schindelmann Patentanwaltsgesellschaft mbH

(57) **Abstract**

In an embodiment, an optical power converter includes a container (110) with a light input port (120) and an electrical output terminal (134, 136). A fluid can be inside the container (110). A converter device (140, 141) contacts the fluid inside the container (110). The converter device (140, 141) includes a photovoltaic element (150) that converts light into electrical power. The light travels through the fluid before reaching the converter device (140, 141). In some examples, the converter device (140, 141) may be a multijunction photovoltaic semiconductor device. The fluid (300) may be an insulating oil or a cryogenic liquid in some examples. In general, the fluid promotes heat transfer away from the converter device (140, 141) and may permit the optical power converter to function at a higher input power and/or with greater efficiency. The fluid may make direct contact with the photovoltaic element (150) in some examples.

## Description

### BACKGROUND

Optical power converter (OPC) devices have many potential applications. For example, OPC devices are being developed for optical wireless power transmission (OWPT), for efficient high-power analog opto-couplers, and for power-over-fiber (PoF) applications at different transmission distances. For such applications, OPCs provide galvanic isolation between the energy input and the devices to be powered. In many applications, vertical multijunction laser power converters (LPCs), which are a type of optical power converter, can be used for enabling optically powered probes, sensors, and electronic subsystems. LPCs may be designed for various spectral, power, and temperature ranges and have been demonstrated to be stable and reliable for different power-over-fiber or power-beaming applications. However, the power output requirements for many such applications are high and increasing, which makes issues related to heat generation and dissipation in OPC devices more important to address.

Since conversion of input light power to electrical output power is never perfectly efficient, waste heat will always be generated by OPC devices during operations. Additionally, conversion efficiency often degrades with changing load conditions and with increased temperatures causing even worse heating and, potentially, can lead to device failure. Therefore, for power-demanding applications, where fraction of a watt, watts, tens of watts, hundreds of watts, or kilowatts of output power are to be provided, additional heat dissipation strategies for OPC devices are desirable. In general, adequate heat management is required to permit better optical power conversion efficiencies and avoid device overheating, performance degradations, and device failures.

Existing approaches to heat management in OPC devices are those previously developed for electronic and opto-electronic components, such as incorporation of thermal heat sinks, high thermal conductivity attachment strategies, fans, radiators, and the like. Most such solutions require additional costs, equipment and/or bulky designs that might not be suitable in all potential applications.

### SUMMARY

In an embodiment, an optical power converter includes a container with a light input port and an electrical output terminal. A liquid is inside the container. A converter device contacts the liquid inside the container. The converter device includes a photovoltaic element that converts light into electrical power. The light travels through the liquid before reaching the converter device. In some examples, the converter device may be a multijunction photovoltaic device.

In an embodiment, an optical power converter includes a container with an electrical output terminal for outputting electrical power and an entrance port for receiving light from a light source via an optical fiber. A liquid is inside the container. An optical power converter device contacting the liquid inside the container. The optical power converter device comprises a multijunction photovoltaic element that convert lights into electrical power and outputs the electrical power at greater than 2 volts. The light from the optical fiber travels through the liquid before reaching the optical power converter device.

In an embodiment, an optical power converter system includes a light source and an optical power converter. The optical power converter includes a container with a light input port and an electrical output terminal. A liquid is inside the container. A converter device contacting the liquid inside the container. The converter device includes a photovoltaic element that converts light from the light source into electrical power. The light from the light source travels through the liquid before reaching the converter device.

As used in the present disclosure, terms such as "has," "with," "includes," or "including," when used in a manner such as component X has/with/includes component Y, is non-exclusive and open-ended so as to indicate component X comprises components Y such that other aspects, components, or elements other than component Y may also be a part of component X.

### BRIEF DESCRIPTION OF THE DRAWINGS

Fig. 1 is a schematic depiction of an OPC system according to an embodiment.
Fig. 2 depicts aspects of an OPC system according to a first embodiment.
Fig. 3 depicts aspects of an OPC system according to a second embodiment.
Fig. 4 planar view of one example of an OPC device.
Fig. 5 side view of a subcell array of an OPC device.
Fig. 6 is a schematic depiction of a use case of an OPC system according to an embodiment.

### DETAILED DESCRIPTION

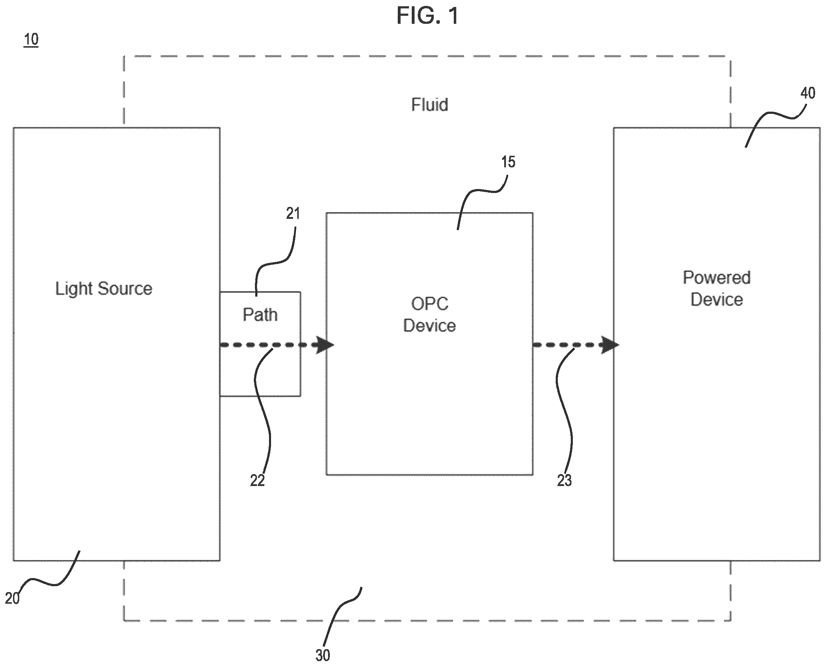

Fig. 1 schematically depicts an optical power converter (OPC) system 10 that includes a light source 20 providing input light 22 to OPC device 15. OPC device 15 photovoltaically converts input light 22 into electrical power 23 that can be supplied to energize a powered device 40. Input light 22 travels from light source 20 through light transmission path 21 to the OPC device 15. The light transmission path 21 may be air, gas, liquid, vacuum, optical fiber, non-fiber glasses and resins, or combinations of such media. The light transmission path 21 may comprise optical elements such as lenses, filters, mirrors, prisms, gratings, and the like in some examples.

OPC device 15 is immersed in and/or filled with fluid 30. Fluid 30 is primarily provided to manage the heat unavoidably generated by OPC device 15 in its light conversion process but may also provide additional benefits related to device electrical properties, performance, stability, or reliability. In general, the presence of fluid 30 permits OPC device 15 to operate at higher power levels and/or with improved efficiency than would otherwise be possible. Fluid 30 may be an insulating oil or a cryogenic liquid, in some examples.

As depicted in Fig. 1, input light 22 passes through fluid 30 before conversion by OPC device 15. In some examples, when fluid 30 is within at least a portion of light path 21 or OPC device 15, the light path 21 may extend all the way to OPC device 15. Light source 20 may itself be immersed in fluid 30 in some examples. In Fig. 1, the outer boundary designation for fluid 30 is depicted as a dashed line to indicate the possibility of variations in the presence of fluid 30 within OPC system 10. Some or all of light source 20 may be immersed in fluid 30. Some or all of powered device 40 may be immersed in fluid 30. Some or all of light path 21 may be immersed in fluid 30. In general, OPC device 15 will be in contact with fluid 30 and, in some examples, may be fully immersed therein, but in other examples, only some portions of OPC device 15 may be in direct contact with fluid 30 while other portions are not. As used in this context, "immersed" encompasses both full and partial immersion of a component in a fluid as well as full or partial coverage or contact of a component by a fluid.

OPC device 15 may be used in any potential application for an optical power conversion device, such as optical couplers, power-over-fiber (PoF) applications, optical wireless power transmission (OWPT), power beaming, or any application in which galvanic or electromagnetic interference (EMI) isolation between energy input and the device to be energized is desirable or required. OPC device 15 may be used with optically powered probes, sensors, and electronic subsystems. OPC device 15 may be designed for a high-voltage environment such as in power electronics for applications in which kilowatts of power are supplied. In general, high-voltage/high-power/high-current applications involve potentially high operating temperatures. Fluid 30 can be used to remove/dissipate heat generated by OPC device 15.

Typically, the presence or inclusion of a fluid 30 or the like in the light input pathway would be considered a hindrance to the normal operations of photovoltaic devices and something that should be avoided. Such systems and/or components for such systems are often carefully sealed against liquid or even atmospheric intrusions. Here, however, OPC device 15 makes direct contact with fluid 30, and input light 22 travels directly through fluid 30 for at least some portion of the path between light source 20 and OPC device 15.

In some examples, light conversion efficiency may be improved for OPC device 15 by the presence of a fluid 30 that permits the junction temperature of OPC device 15 to be kept at, or closer to, an optimal temperature during conversion operations. In some examples, fluid 30 may be a cooled, chilled, or cryogenic liquid. For certain designs for OPC devices 15 involving receiver arrays of OPC elements that are densely packed, inter-element dielectric breakdown may be a concern or a design limitation, and the presence of a fluid 30 with a higher dielectric constant than air or insulators between such elements can avoid potential inter-element breakdowns and/or permit more densely packed receiver arrays.

Powered device 40 may, in general, be any apparatus, device, machine, object, or system to which electrical power 23 may be supplied. Powered device 40 may be, without limitation, a battery, a sensor, a probe, a motor, a computer, an electronic component, or an electrical appliance. Some or all of powered device 40 may be immersed in fluid 30. In some examples, powered device 40 may be separated from and/or sealed against fluid 30. OPC device 15 may be integrated within powered device 40 as a sub-component or the like. OPC device 15 may be mounted on or inside a powered device 40 or may merely be electrically connected to a powered device 40 in some manner, such as by conductive wires, pins, or the like.

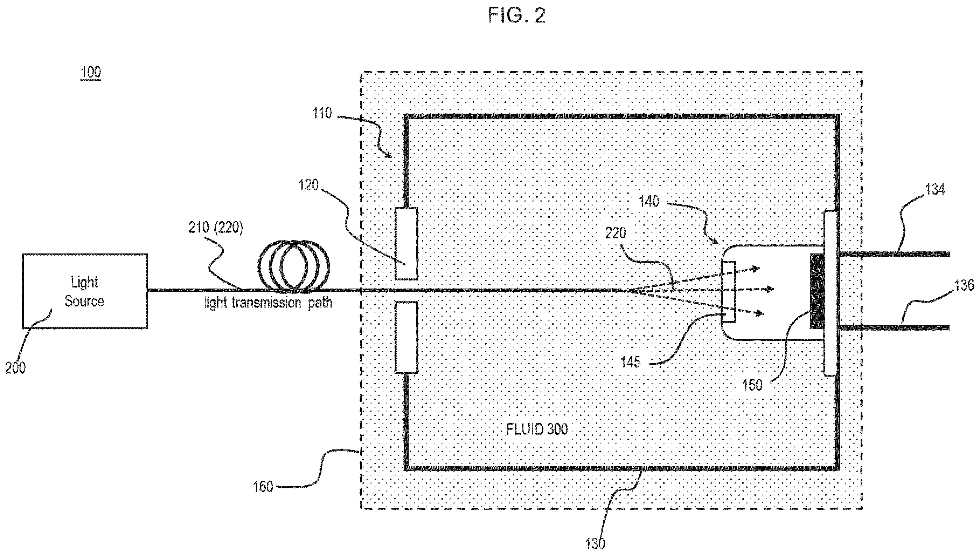

Fig. 2 depicts an optical power converter (OPC) system 100 according to a particular first embodiment. OPC system 100 includes a OPC container 110 (also referred to as a containerized OPC device). OPC container 110 includes a casing 130 functioning as an outer shell or the like. The OPC container 110 receives input light 220 from light source 200 via optical fiber 210. Optical fiber 210 (a light transmission path) is received by OPC container 110 at the entrance 120 (an entrance port). Entrance 120 can be a ferrule or other physical attachment structure permitting the optical fiber 210 (or light therefrom) to penetrate the casing 130 of OPC container 110. In some examples, entrance 120 may be a window or opening through which input light 220 can pass. Entrance 120 may incorporate fiber attachment structures permitting optical fiber 210 to be connected to the OPC container 110 without penetrating into OPC container 110.

Inside the casing 130, there is an OPC device 140 that has a OPC chip 150 (a photovoltaic element) that receives light and provides an electrical output at external outputs 134 and 136. OPC device 140 and/or casing 130 may incorporate gridlines, busbars, terminals, wirebonds, tab connectors, or the like by which the electrical output from OPC chip 150 is supplied to the external outputs 134 and 136. The OPC device 140 incorporates a window 145 to permit light from optical fiber 210 to reach the OPC chip 150 for conversion. The OPC device 140 in this first embodiment is sealed, such as hermetically sealed.

In this example, a fluid 300 is present inside the OPC container 110. Fluid 300 may also be additionally present outside OPC container 110 and thus a secondary containment structure 160 surrounding OPC container 110 may also be provided as depicted. Secondary containment structure 160 may be omitted or optional in some examples, and casing 130 may be the outermost fluid container of the OPC system 100. Fluid 300 is not present inside OPC device 140 and thus does not make direct contact with OPC chip 150 in this embodiment.

In the depicted example, input light 220 exits optical fiber 210 at a point inside OPC container 110 and travels through fluid 300 before reaching OPC device 140 (window 145). In other examples, input light 220 may exit optical fiber 210 outside the OPC container 110. Or when the light transmission path does not include an optical fiber 210 at all, input light 220 may enter OPC container 110 as a beam, ray, or the like.

Fluid 300 in the first embodiment is provided primarily for heat management purposes. The heat management of the fluid can originate from its properties of heat conduction, heat convection, heat capacity, latent heat, phase transitions, or the like. With casing 130 filled with fluid 300, heat generated by OPC device 140 (OPC chip 150) can flow to fluid 300 and OPC chip 150 can operate at a more optimal or desirable temperature than would otherwise be possible without fluid 300. Fluid 300 may simply serve as a heat sink and/or may be actively or passively circulated within, or through, OPC container 110. Fluid 300 may be chilled or otherwise temperature controlled in some examples. Secondary containment structure 160 may incorporate recirculating mechanisms, chillers, heat exchangers, heat pipes, and the like to maintain fluid 300 at a desirable temperature.

In general, fluid 300 may be any liquid through which light 220 can pass to ultimately reach OPC chip 150 for conversion. Liquids that are non-corrosive, easy to handle, low volatility, nonflammable, electrically non-conductive, environmentally safe, and inexpensive are generally preferable to those that are not, but no particular limitations on fluid 300 are to be implied by such potential considerations.

In one example, fluid 300 is an insulating oil, such as electrical transformer filling oil, vegetable oil, synthetic oil, or mineral oil. Many insulating oils are non-corrosive and have good electrical insulating properties making them particularly compatible with high power electrical component applications.

In another example, fluid 300 is a cryogenic liquid, such as liquid nitrogen, liquid argon, liquid xenon, liquid neon, liquid krypton, or liquid helium. The low temperatures of these liquids can also help improve conversion efficiency by maintaining junction temperature in OPC chip 150 at a low temperature.

Fluid 300 is preferably selected to provide high transmission (low absorbance) of input light 220. Input light 220 will often be substantially monochromatic, and fluid 300 may be selected in view of the wavelength and the numerical aperture of input light 220 to be used.

Light source 200 is shown in Fig. 2 as part of OPC system 100. This is for purposes of depictional simplicity in the drawings. In some embodiments, light source 200 may indeed be provided as an integrated part (sub-component) of OPC system 100. In other embodiments, light source 200 may be provided separate from OPC system 100. OPC system 100 will usually be designed with a specific light source 200 in mind. In particular, input light 220 from light source 200 will usually have a known (expected) power or intensity range, wavelength range, and optical fiber 210, OPC device 140, OPC chip 150 and other components will be selected accordingly. Light source 200 may comprise a laser, a light-emitting-diode (LED), a lamp, ambient light, daylight, sunlight, or combinations of such sources. Light source 200 may be a commercially available edge-emitting semiconductor laser, a vertical-cavity surface-emitting laser (VCSEL), or the like.

Optical fiber 210 is one example of a light transmission path. Optical fiber 210 may be a glass, a polymer, a resin, or the like through which input light 220 will travel, preferably without substantial loss. In some embodiments, another type of light transmission medium may replace optical fiber 210 and optical fiber 210 may be omitted. The light transmission medium in such cases may be air, gas, vacuum, non-fiber glasses, polymers, and resins, or combinations of such media. In such cases, entrance 120 may comprise optical elements such as lenses, filters, mirrors, prisms, gratings, and the like. Similarly, the light transmission path for input light 220 through any light transmission medium may incorporate lenses, filters, mirrors, prisms, gratings, and the like.

OPC container 110 may, in general, have any shape, size, or outer form. OPC container 110 may incorporate various materials and additional components such as ports, inlets, outlets, terminals, connectors, couplings, fastening points, and the like. OPC container 110 may comprise separate parts that are joined together to form a unitary whole. OPC container 110 may incorporate passive or active thermal heat sink components and/or heat dissipation components.

Casing 130 of OPC container 110 may be any material and may incorporate additional ports, inlets, outlets, connectors, couplings, fastening points, and the like. Casing 130 may comprise separate parts that are joined together to form a unitary whole. Casing 130 may incorporate thermal heat sink components and/or heat dissipation components. To promote heat dissipation and thermal exchange with fluid 300, casing 130 may incorporate fins, vanes, grooves, channels, or other structures for directing or guiding the flow of fluid 300. Leads, terminals, pins, or wirings may be attached to, or integrated with, casing 130. As depicted, external electrical outputs 134 and 136 are provided as pins, in particular, electrically isolated metal pins fed through casing 130.

Secondary containment structure 160 may, in general, have any shape, size, or outer form. Secondary containment structure 160 may be any material and may incorporate additional ports, inlets, outlets, connectors, couplings, fastening points, and the like. Secondary containment structure 160 may comprise separate parts that are joined together to form a unitary whole. Secondary containment structure 160 may incorporate thermal heat sink components and/or heat dissipation components. In some examples, secondary containment structure 160 may simply be a space within a larger apparatus in which OPC system 100 is installed. Secondary containment structure 160 may also encompass the light source 200 within its interior region in some examples. Secondary containment structure 160 may provide fluid handling systems, reservoirs, recirculating mechanisms, cooling equipment, heat exchangers, and the like related to flow control, supply, replenishment, maintenance, and handling of fluid 300.

OPC device 140 is depicted with a basic form factor corresponding to that of existing packaged optical power conversion components, but is not limited thereto. OPC device 140 may, in general, have any shape, size, or outer form. OPC device 140 may include an outer casing structure that may be any material and may incorporate additional ports, inlets, outlets, connectors, couplings, fastening points, and the like. OPC device 140 may comprise separate parts that are joined together to form a unitary whole. OPC device 140 may incorporate thermal heat sink components and/or heat dissipation components. To promote heat dissipation and thermal exchange with fluid 300, OPC device 140 may incorporate fins, grooves, channels, or other structures. Leads, terminals, pins, or wirings may be attached to or integrated with OPC device 140. OPC device 140 electrically connects to external outputs 134 and 136 in this example. The external outputs 134 and 136 may be integral portions of the OPC device 140. OPC device 140 may incorporate gridlines, busbars, terminals, wirebonds, tab connectors, or the like by which the electrical output is supplied to the external outputs 134 and 136.

Window 145 of OPC device 140 may be any material through which input light 220 can pass. In the present example, OPC device 140 (in conjunction with window 145) is hermetically sealed and the enclosed interior of casing OPC device 140 is filled with nitrogen gas or other inert gas. Fluid 300 is kept from intentional contact with the active element surface of OPC chip 150 in this embodiment.

OPC chip 150 is the active element of OPC device 140 that converts incident light to electricity. OPC chip 150 may be referred to more broadly as a photovoltaic device or photovoltaic element. In the present example, OPC chip 150 is a photovoltaic semiconductor device, more particularly a multi-junction photovoltaic semiconductor device that is capable of converting optical power into electrical power at an output voltage of greater than 2 volts (2V).

The OPC chip 150 may be optimized to function at a particular wavelength of light. In some examples, OPC chip 150 may be a gallium-arsenide (GaAs)-based device or an indium-phosphate (InP)-based device with ternary and quaternary compound semiconductors. GaAs-based devices are preferably used for the wavelength range between 750nm and 950nm. InP-based devices are preferably used for the wavelength range between 950nm and 1750nm. OPC chip 150 may incorporate a semiconductor substrate, such as a GaAs substrate, and InP substrate, a silicon substrate, a gallium nitride (GaN) substrate, a sapphire substrate, a silicon carbon (SiC), a virtual substrate, a metamorphic substrate, or composite substrates comprising combinations of such substrates.

OPC device 140 may comprise a plurality of active photovoltaic elements interconnected with one another, each of which is designed to absorb some fraction of the incoming light. The output voltage generated by absorbing photovoltaic elements connected in series are additive. Such an arrangement of photovoltaic elements may be referred to a multijunction photovoltaic device. For example, output voltage of a multijunction photovoltaic device may be a few volts up to several tens of volts. For example, OPC device 140 may be a multijunction photovoltaic device. OPC device 140 may be a so-called, vertical multijunction photovoltaic device. OPC device 140 may comprise p/n junctions and subcells. OPC device 140 may comprise tunnel junction layers interconnecting p/n junctions or subcells. The OPC device 140 may be a heterostructure based on so called compound semiconductors and incorporating p-type and n-type dopants.

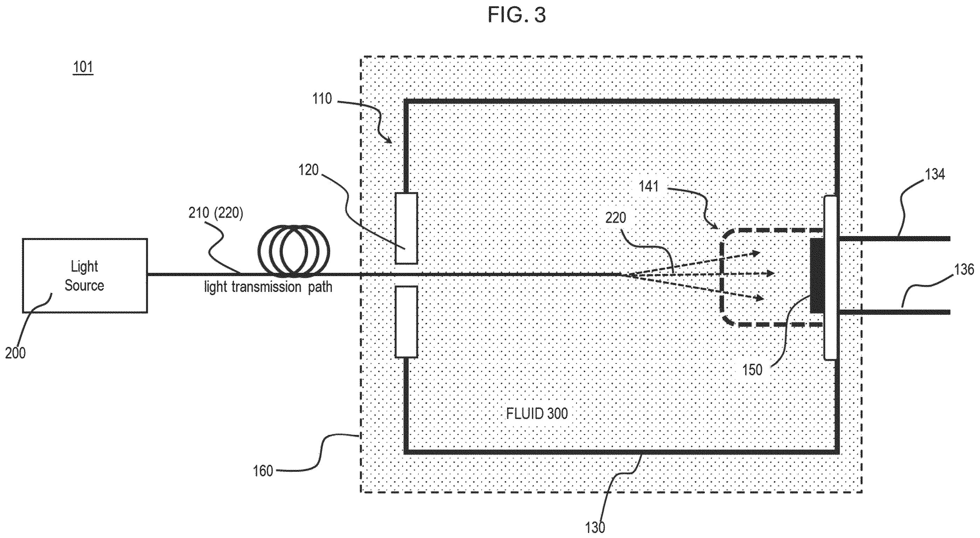

Fig. 3 depicts an OPC system 101 according to a second embodiment. In general, OPC system 101 is similar to the already-described OPC system 100 and description will focus on differences. Aspects in Fig. 3 that are substantially similar to those in Fig. 2 have the same reference symbols.

In OPC system 101, OPC device 141 (as compared to OPC device 140) lacks any corresponding window 145 component and associated housing structure such that fluid 300 can reach OPC chip 150. That is, fluid 300 may directly contact the active surface side of OPC chip 150 in this embodiment. In addition to a lack of a window 145, OPC device 141 need not have any upper casing-like or housing-like structure (a dashed line is used to depict as optional structure).

OPC device 141 may otherwise have a form factor corresponding to that of existing packaged optical power conversion components, but is not limited thereto. OPC device 141 may, in general, have any shape, size, or outer form. OPC device 141 may incorporate outer structure that may be any material and may incorporate additional ports, inlets, outlets, connectors, couplings, fastening points, and the like. OPC device 141 may comprise separate parts that are joined together to form a unitary whole. OPC device 141 may incorporate thermal heat sink components and/or heat dissipation components. To promote heat dissipation and thermal exchange with fluid 300, OPC device 141 may incorporate fins, vanes, grooves, channels, or other structures. Leads, terminals, pins, or wirings may be attached to or integrated with OPC device 141. OPC device 141 electrically connects to external outputs 134 and 136 in this example. OPC device 141 may incorporate gridlines, busbars, terminals, wirebonds, tab connectors, or the like by which the electrical output is supplied to the external outputs 134 and 136.

By permitting direct contact between OPC chip 150 and fluid 300, OPC system 101 may be considered to provide enhanced thermal exchange between the active regions/elements of OPC device 141 and fluid 300 and thus may provide improved thermal stability and/or control. By permitting direct contact between OPC chip 150 and fluid 300, OPC system 101 may be considered to provide an enhanced dielectric constant environment for the active regions/elements of OPC device 141 and thus may provide improved electrical breakdown characteristics. By permitting direct contact between OPC chip 150 and fluid 300, OPC system 101 may be considered to provide a passivation environment for the active regions/elements of OPC device 141 and thus may provide improved durability or reliability characteristics. Conversion efficiency may be improved in some instances by improved thermal control in the active junction regions. There may also be less structural complexity associated with a non-sealed device, and removing heat from a non-sealed device may be easier. There may also be less concern with possible device failure modes that might otherwise be associated with unintended impingement of fluid 300 into an OPC device 140 or the like.

However, additional considerations in the selection of a suitable fluid 300 may be necessary in view of the direct contact between fluid 300 and semiconductor components (e.g., OPC chip 150). Though, it should be noted, that the lack of an outer casing type structure or window 145 does not necessarily mean OPC chip 150 must be entirely without packaging, protective coatings, coverings, or the like that might serve to prevent unwanted interactions with fluid 300 or otherwise. For example, certain regions or portions of OPC chip 150 may be sealed or covered with a resin other protective coating. Openings in the resin or other protective coating may be provided in some regions. The OPC chip 150 may be mounted to casing 130 in such a way as to prevent fluid 300 from contacting the backside of OPC chip 150. Mounting structure for OPC chip 150 may be provided as part of casing 130 or otherwise to seal the backside of OPC chip 150 from contact with fluid 300.

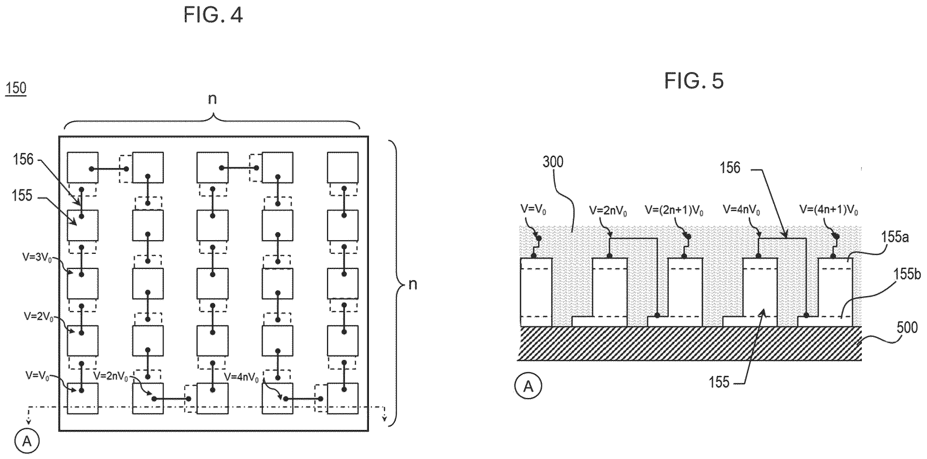

Fig. 4 depicts a planar view of one example of an OPC chip 150. As seen from overhead (generally, a light incidence direction for OPC chip 150), there is an n×n array of light-absorbing subcells 155. Certain adjacent subcells 155 in the array are electrically connected to each other by interconnectors 156. The connections (interconnections) allow OPC chip 150 to output higher voltages.

Subcells 155 connected in series serve to boost total supplied voltage. For example, a single subcell 155 may provide an output voltage of Vₒ, but n² subcells connected in series would provide an output voltage of n² × Vₒ. Given particular arrangements and interconnections, the voltage difference between certain adjacent subcells 155 can be as high as (2n-1)Vₒ. When the space between adjacent subcells 155 is filled with a fluid 300 that that is an insulating oil, electrical breakdown between adjacent cells can be suppressed as compared to the case where air or an inert gas fills the space since generally such gases have a lower effective dielectric constant. Thus, fluid 300 can permit the subcells 150 to be packed more densely (shorter distance d) or, alternatively, operate at higher voltages (e.g., a larger Vₒ).

Fig. 5 shows a side view of the OPC chip 150 depicted in Fig. 4 along with the presence of fluid 300 such as when used in OPC system 101. As seen in Fig. 5, OPC chip 150 includes a substrate 500 on which the subcells 155 are provided. The interconnectors 156 are shown schematically. Each subcell 155 has an upper connector portion 155a and a lower connector portion 155b. The lower connector portion 155 may, in some examples, extend beyond the upper connector portion 155a of the same subcell 155 in a direction parallel to the substrate 500. For example, the lower connection portion 155b may extend outwardly towards the one of the adjacent subcells 155 to which the subcell 155 connects to via an interconnector 156.

The interconnectors 156 electrically connect to these upper connector portions 155a and lower connector portions 155b. In general, interconnectors 156 may be any conductive component, wiring, electrical trace, connector, or the like. Interconnectors 156 may also include insulating layers, coatings, or the like in regions in which electrical connections are not intended.

As depicted in the figures, n is equal to 5, but there is no particular limitation on the value of n. Similarly, while a square array is depicted, this is not required and the number of subcells 155 along each array direction may be different. The array may instead be irregular in shape, disposed in spiral pattern, or the like. Spacing between adjacent subcells 155 need not necessarily be constant in each instance. An OPC chip 150 may include multiple arrays. Such multiple arrays may be the same or different in layout, arrangement, shape, spacing, fabrication techniques, or materials.

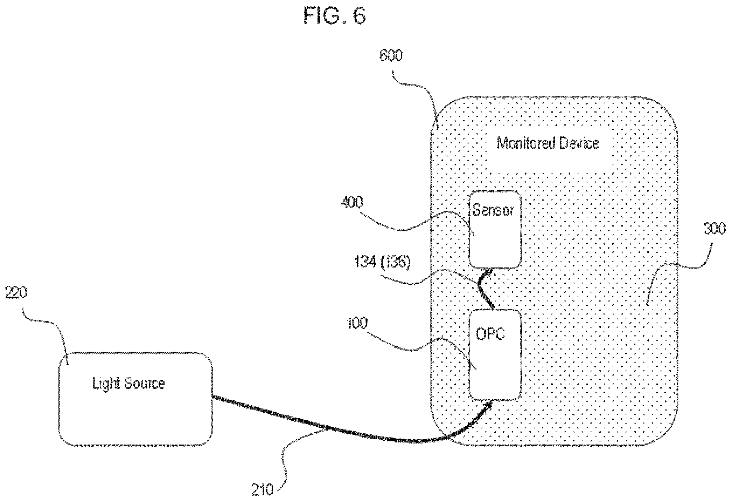

Fig. 6 depicts a particular use of an OPC system 100. In Fig. 6, power (light) is fed to OPC system 100 via optical fiber 210 from a light source 200 that is external to a monitored device 600 in which OPC system 100 is mounted. The external electrical outputs 134 and 136 of OPC system 100 are connected to a sensor device 400. Electrical power generated by OPC system 100 is used to operate sensor device 400. Fluid 300 is present in at least some portion of monitored device 600 as well as in OPC system 100. Sensor device 400 operates on the electrical power supplied by electrical outputs 134 and 136 and measures some characteristic of the monitored device 600. Sensor device 400 may then wirelessly report the measured values to another device or system.

One or more embodiments of the present invention may be implemented in conjunction with one or more computer programs or as one or more computer program modules embodied in computer readable media. The term computer readable medium refers to any data storage device that can store data which can thereafter be input to a computer system. Computer readable media may be based on any existing or subsequently developed technology that embodies computer programs in a manner that enables a computer to read the programs. Examples of computer readable media are hard drives, network-attached storage (NAS) systems, read-only memory (ROM), RAM, compact disks (CDs), digital versatile disks (DVDs), magnetic tapes, and other optical and non-optical data storage devices. A computer readable medium can also be distributed over a network-coupled computer system so that the computer readable code is stored and executed in a distributed fashion.

Although one or more embodiments of the present disclosure have been described in some detail for clarity of understanding, certain changes may be made and still be within the scope of the claims. Accordingly, the described embodiments are to be considered as illustrative and not restrictive or limiting, and the scope of the claims is not to be considered limited to details given herein but may be modified within the scope of the claims and equivalents. In the claims, any recitation of elements and/or steps do not imply any particular order of operation or incorporation unless explicitly stated in the claims.

Depicted boundaries between components, elements, devices, and units are somewhat arbitrary, and while particular boundaries may have been illustrated in the context of specific example configurations, other boundaries, divisions, and/or allocations of functions, components, elements, or aspects may be possible or available. Such other allocations of functionality and/or components are envisioned and should be considered to fall within the scope of the present disclosure. In general, structures and functionalities presented as separate components in exemplary configurations may be implemented as a combined structure or component. Similarly, structures and functionalities presented as a single component may be implemented as separate components. These and other variations, additions, alternations, and improvements may fall within the scope of the appended claims.

## Claims

1. An optical power converter, comprising:
A container (110) comprising a light input port (120) and an electrical output terminal (134, 136);
a liquid (300) inside the container (110);
a converter device (140, 141) contacting the liquid (300) inside the container (110), wherein
the converter device (140, 141) comprises a photovoltaic element (150) configured to convert light into electrical power, and
the light is configured to travel through the liquid (300) before reaching the converter device (140, 141).

2. The optical power converter of claim 1, wherein the liquid (300) has a dielectric breakdown potential that is greater than the dielectric breakdown potential of air.

3. The optical power converter of claim 1 or 2, wherein the converter device (140, 141) is configured to output electrical power at a voltage of greater than or equal to 2 volts.

4. The optical power converter of any of the claims 1 to 3, wherein the converter device (140, 141) is a multijunction photovoltaic device.

5. The optical power converter of any of the claims 1 to 4, wherein the light input port (120) is configured to receive an optical fiber.

6. The optical power converter of claim 5, wherein the optical fiber is configured to extend into the container (110).

7. The optical power converter of any of the claims 1 to 6, wherein the photovoltaic element (150) is in direct contact with the liquid (300).

8. The optical power converter of any of the claims 1 to 7, wherein the converter includes a window and the photovoltaic element (150) is sealed off from direct contact with the liquid (300).

9. The optical power converter of any of the claims 1 to 8, wherein the liquid (300) is an electrically insulating oil.

10. The optical power converter of any of the claims 1 to 9, wherein the liquid (300) is a cryogenic liquid.

11. The optical power converter of any of the claims 1 to 10, wherein the electrical output terminal (134, 136) is an electrically isolated metal pin extending through an outer wall of the container (110).

12. An optical power converter, comprising:
a container (110) comprising an electrical output terminal (134, 136) configured to output electrical power and an entrance port configured to receive light from a light source via an optical fiber;
a liquid (300) inside the container (110);
an optical power converter device (140, 141) contacting the liquid (300) inside the container (110), the optical power converter device (140, 141) comprising a multijunction photovoltaic element (150) that is configured to convert light into electrical power and output the electrical power at greater than 2 volts, wherein
the light from the optical fiber is configured to travel through the liquid (300) before reaching the optical power converter device (140, 141).

13. The optical power converter of claim 12, comprising at least one of the following features:
wherein the liquid (300) is an electrically insulating oil;
wherein the liquid (300) is a cryogenic liquid;
wherein the multijunction photovoltaic element (150) is in direct contact with the liquid (300);
wherein
the optical converter device (140) comprises a window, and
the multijunction photovoltaic element (150) is sealed off from direct contact with the liquid (300).

14. An optical power converter system (10, 100, 101), comprising:
a light source; and
an optical power converter comprising:
a container (110) comprising a light input port (120) and an electrical output terminal (134, 136);
a liquid (300) inside the container (110);
a converter device (140, 141) contacting the liquid (300) inside the container (110), wherein
the converter device (140, 141) comprises a photovoltaic element (150) configured to convert light from the light source into electrical power, and
the light from the light source is configured to travel through the liquid (300) before reaching the converter device (140, 141).

15. The optical power converter system (10, 100, 101) of claim 14, comprising at least one of the following features:
further comprising:
an optical fiber extending between the light source and the optical power converter, wherein
the light source comprises a laser;
wherein the converter device (140, 141) is configured to output electrical power at a voltage of greater than or equal to 2 volts;
wherein the converter device (140, 141) is a multijunction photovoltaic device.
